# FASCICULE DE BREVET EUROPEEN

(11) **EP 2 087 591 B1**
(45) Date de publication et mention de la délivrance du brevet: **21.07.2010**
(21) Numéro de dépôt: 07870272.7
(22) Date de dépôt: 12.11.2007
(51) Int. Cl.: H03K 17/96

(54) **DISPOSITIF ELECTRONIQUE, DESTINE A REALISER LA MESURE ET LA DETECTION DE VARIATIONS D'AU MOINS UN SIGNAL D'ENTREE**
ELEKTRONISCHE VORRICHTUNG ZUR MESSUNG UND ERKENNUNG DER VARIATIONEN MINDESTENS EINES EINGABESIGNALS
ELECTRONIC DEVICE USED FOR THE MEASURING AND DETECTING THE VARIATIONS OF AT LEAST ONE INPUT SIGNAL

(30) Priorité: 10.11.2006 FR 0609849
(43) Date de publication de la demande: 12.08.2009
(73) Titulaire: Lefebvre, Jean-Noel, 69008 Lyon (FR)
(72) Inventeur: Lefebvre, Jean-Noel, 69008 Lyon (FR)
(74) Mandataire: Maureau, Philippe
(86) Numéro de dépôt international: PCT/FR2007/001860
(87) Numéro de publication internationale: WO 2008/068412

(56) Documents cités:
- US-A- 4 169 260
- US-A- 4 222 045
- US-A1- 2005 184 876

## Description

L'invention concerne un dispositif électronique, destiné à la mesure et la détection de variations d'au moins un signal d'entrée à mesurer, ainsi qu'un système comprenant au moins deux dispositif électroniques précités, et un clavier matriciel utilisant ledit dispositif ou système.

Il est connu de réaliser un dispositif de détection et de mesure comportant :
- un premier composant fournissant un signal de sortie dont la fréquence d'oscillation est représentative d'un signal d'entrée,
- un oscillateur de référence,
- un composant de comparaison de phase réalisant une comparaison entre les oscillations du premier composant et de l'oscillateur de référence, notamment en vue d'un asservissement par une boucle de l'oscillateur de référence sur le premier composant, ou du premier composant sur l'oscillateur de référence, ou d'un asservissement mutuel, et
- des moyens de couplage élastique entre le premier composant et l'oscillateur de référence.

Le document US5034722 et le document GB978212 décrivent notamment un tel dispositif.

Le signal obtenu en sortie du composant de comparaison de phase permet d'avoir une indication de la variation du signal issu du premier composant, lui-même représentatif du signal d'entrée.

Le couplage élastique tend à maintenir un déphasage fixe et des fréquences d'oscillation légèrement différentes de la fréquence nominale pour le premier composant et l'oscillateur de référence, une fois que ces deux composants sont amenés à des fréquences nominales proches l'une de l'autre.

Ce couplage permet de réduire les perturbations de la sortie du composant de comparaison de phase dues aux bruits intrinsèques au dispositif, par exemple bruit thermique ou aux bruits extrinsèques au dispositif, par exemple perturbations électromagnétiques.

L'action du couplage est en outre réalisée tout en conservant les faibles variations du signal issu du premier oscillateur, ces faibles variations étant le reflet de l'événement que l'on cherche à détecter ou à mesurer.

Ainsi le couplage permet de rendre le signal de sortie du composant de comparaison de phase exploitable pour la mesure du signal d'entrée.

Il est toutefois souhaitable de perfectionner le type de dispositif présenté ci-dessus pour augmenter la sensibilité de mesure de celui-ci, et pour diminuer sa sensibilité aux perturbations électromagnétiques transitoires.

Il est également souhaitable de permettre un fonctionnement avec plusieurs capteurs qui peuvent s'influencer mutuellement et pour permettre le partage de ressources entre plusieurs capteurs ou électrodes dans le cas de multiplexages.

Le but de la présente invention est donc de fournir un dispositif apportant tout ou partie des avantages suivants : une sensibilité de mesure augmentée, et une sensibilité aux perturbations extérieures diminuée, un fonctionnement facilité avec plusieurs capteurs et un partage de ressource entre plusieurs capteurs.

A cet effet, la présente invention a pour objet un dispositif du type précité, caractérisé en ce qu'il comprend des moyens de synchronisation conçus pour bloquer ou autoriser alternativement l'influence des oscillations du premier composant sur le composant de comparaison de phase et sur les moyens de couplage élastique, et des moyens de détermination d'un signal dérivé de l'évolution du signal de sortie du composant de comparaison de phase.

Le fonctionnement se fait en régime transitoire, à chaque déblocage de l'influence du premier composant sur le composant de comparaison de phase.

A chaque fois que les oscillations du premier composant atteignent l'entrée du composant de comparaison de phase, le signal de sortie du composant de comparaison de phase rejoint progressivement sa valeur nominale, c'est à dire celle du régime établi si le signal du premier composant n'avait pas été bloqué.

La pente du signal de sortie du composant de comparaison de phase pendant chaque période où les oscillations du premier composant atteignent l'entrée du composant de comparaison de phase, c'est-à-dire la vitesse à la quelle le premier composant et l'oscillateur de référence reviennent en phase est directement influencée par trois facteurs:
- La valeur des fréquences nominales du premier composant et de l'oscillateur de référence au point de fonctionnement
- La « force» du couplage élastique
- La différence des deux fréquences nominales du premier composant et de l'oscillateur de référence : plus les fréquences nominales sont proches, plus la remise en phase est rapide.

En conséquence, dans ce dispositif, la variation de la grandeur physique à mesurer est donnée par la pente du signal de sortie du composant de comparaison de phase durant la phase où les oscillations du premier composant atteignent l'entrée du composant de comparaison de phase..

L'utilisation du signal dérivé apporte une augmentation notable de la sensibilité du dispositif par rapport aux systèmes de l'état de la technique.

Ces dispositifs peuvent être utilisés dans des applications très diverses, notamment dans le cadre de la détection de personnes, de la réalisation de surfaces tactiles au travers d'un isolant, ou de la réalisation de surfaces sensibles à la pression.

Avantageusement, les moyens de couplage élastiques sont conçus pour réaliser un couplage asymétrique de façon à ce que l'influence du premier composant sur l'oscillateur de référence soit supérieure à l'influence de l'oscillateur de référence sur le premier composant.

Avantageusement, les moyens de couplage élastiques sont conçus pour réaliser un couplage unidirectionnel de façon à ce que le premier composant influence l'oscillateur de référence.

Le mode unidirectionnel du couplage permet de déporter le premier composant à distance sans nécessiter de déporter la liaison de couplage qui reste locale au circuit de conditionnement de signal en aval de ce premier composant. En effet, aucun signal provenant de l'oscillateur de référence n'est retourné vers le premier composant.

Ainsi le premier composant peut être relié de façon filaire à quelques mm ou à quelques mètres de distance de câblage des autres composant du dispositif.

Le premier composant peut également être déporté à longue distance en utilisant dans ce cas une liaison à distance entre ce premier composant et les autres composant du dispositif. Cette liaison à distance peut être de tout type, par exemple optique, radiofréquence, ultrasonore, ou par un réseau informatique.

Le mode unidirectionnel du couplage permet également d'insérer un diviseur ou un multiplieur de fréquence en aval du premier composant et en amont des moyens de couplage élastique, ce qui permet de changer la fréquence de travail. Par exemple, si la fréquence de travail du premier composant est de l'ordre de 1 Mhz, en utilisant un diviseur par 10, il est possible de ramener cette fréquence à 100Khz, ce qui facilite le traitement des signaux.

Selon un mode de réalisation, les moyens de détermination d'un signal dérivé de l'évolution du signal de sortie du composant de comparaison de phase comprennent un composant de mesure de pente du signal de sortie du composant de comparaison de phase.

Selon un autre mode de réalisation, les moyens de synchronisation réalisent des blocages à fréquence fixe, et les moyens de détermination d'un signal dérivé de l'évolution du signal de sortie du composant de comparaison de phase comprennent un composant de mesure de crête du signal à la fin d'une période de déblocage.

Ces dispositions permettent de réaliser simplement un calcul approché de la pente de la courbe.

Selon une première possibilité, le premier composant est un oscillateur relié à un capteur de mesure d'une grandeur physique à mesurer.

Selon une seconde possibilité, le premier composant est un récepteur d'un signal extérieur au dispositif.

Avantageusement, le récepteur est conçu pour recevoir un signal de communication en modulation de fréquence.

De préférence, le dispositif comporte un composant de commande de l'asservissement de l'oscillateur de référence ou du premier composant.

Avantageusement, le dispositif comprend un composant de mémorisation, permettant de maintenir, selon un mode de fonctionnement, une tension de consigne constante pour la commande de l'oscillateur de référence ou du premier composant pendant une durée déterminée.

Ces dispositions correspondent à une utilisation en boucle ouverte.

Préférentiellement, dans un mode de fonctionnement, les moyens de détermination d'un signal dérivé sont reliés par une boucle à l'oscillateur de référence ou au premier composant pour appliquer une consigne de correction avec une constante de temps dont l'ordre de grandeur est supérieur à celui des variations du signal d'entrée et inférieure à celui de la dérive de ce signal.

Ainsi, dans ce mode de fonctionnement, une compensation permettant de réduire les effets de variations lentes et/ou de la dérive du signal est réalisée, sans influence sur la détection des variations rapides et de faible amplitude que l'on cherche à mesurer ou détecter.

Une telle compensation est nécessaire dans le cas où cette variation lente ou cette dérive est trop importante pour qu'une mesure des variations rapides soit réalisée avec précision.

Selon une caractéristique de l'invention, la constante de temps peut être réglée à une première valeur dans un mode de calibration et à une seconde valeur, supérieure à la première, dans un mode de compensation.

Dans le cas où la constante de temps est faible, le signal issu de l'oscillateur est corrigé ou compensé rapidement, le signal de référence pour la compensation étant le signal issu du premier composant. On obtient ainsi un calibrage rapide du dispositif.

Au contraire, en phase de mesure, la constante de temps est réglée de manière à ce qu'elle soit suffisamment grande pour que les variations rapides et d'amplitude faible du signal issu du premier composant ne soient pas effacées par la compensation. Il est à noter que, dans ce cas, la compensation permet tout de même de restreindre l'effet néfaste, notamment en terme de précision, des variations lentes et d'amplitude importante.

Ainsi, la mesure et la détection des variations faibles et rapides, représentatives du phénomène à observer, ne sont pas polluées par les variations lentes non représentatives.

De préférence, dans un mode de fonctionnement, le bouclage entre la sortie des moyens de détermination d'un signal dérivé et l'oscillateur de référence ou le premier composant est supprimé, le point de fonctionnement étant maintenu par le composant de mémorisation.

Avantageusement, dans un mode de fonctionnement, le bouclage entre la sortie des moyens de détermination d'un signal dérivé et l'oscillateur de référence ou le premier composant est supprimé si la valeur du signal dérivé ou la pente due à la variation de cette valeur est supérieure à un premier seuil déterminé, les moyens de détermination d'un signal dérivé étant à nouveau reliés par une boucle à l'oscillateur de référence ou au premier composant si la valeur du signal dérivé ou la pente due à la variation de cette valeur est inférieure à un second seuil déterminé.

Ainsi, entre le début et la fin d'un événement physique, délimité par chacun des premiers et seconds seuils, on opère un découplage permettant d'éviter toute compensation pendant la durée de l'évènement. La mesure obtenue en sortie des moyens de détermination d'un signal dérivé n'est donc pas affectée par la compensation.

Ce mode de fonctionnement est nécessaire lorsque l'événement à mesurer est de durée importante.

Avantageusement, le dispositif est destiné à réaliser la mesure et la détection de variations d'au moins deux signaux d'entrée, les moyens de synchronisation permettant de traiter sélectivement l'un des signaux d'entrée.

Ces dispositions permettent une mise en commun de la plupart des composants et donc une simplification du dispositif pour le traitement de plusieurs signaux d'entrée.

Selon un mode de réalisation, le dispositif comprend au moins deux capteurs de mesure et des moyens de commutation commandés par les moyens de synchronisation pour traiter sélectivement le signal provenant de l'un des capteurs de mesure, un oscillateur unique étant situé en aval des moyens de commutation, cet oscillateur pouvant être bloqué par les moyens de synchronisation.

Ces dispositions permettent de mutualiser de façon importante les composant utilisés pour les différents signaux d'entrée. Ces dispositions permettent de réaliser efficacement un dispositif comprenant plusieurs capteurs de même nature.

Selon un autre mode de réalisation, le dispositif comprend au moins deux capteurs de mesure et un oscillateur associé à en aval de chacun des capteurs de mesure, les moyens de synchronisation étant conçus pour sélectionner la sortie d'un oscillateur à traiter et pour bloquer la sortie de ces oscillateurs.

Ces dispositions permettent d'utiliser des capteurs hétérogènes, par exemple un capteur capacitif, un capteur inductif et un capteur à ultrasons dans le même dispositif.

La présente invention a également pour objet un système comprenant au moins deux dispositifs selon l'invention, comprenant des moyens de synchronisation communs permettant de bloquer alternativement les oscillations du premier composant des différents dispositifs du système.

Ces dispositions permettent de faire fonctionner plusieurs dispositifs simultanément dans un même environnement, dans un mode de fonctionnement alterné.

En effet, les premiers composants constituant les composants de mesure des différents dispositifs étant placés dans un même environnement, ils exercent les uns sur les autres une influence par le biais de différents couplages, par exemple un couplage au niveau du procédé physique de mesure ou un couplage électromagnétique des circuits électroniques.

Si cette influence est telle qu'elle ne peut être négligée, l'utilisation simultanée des dispositifs n'est pas possible.

Grâce aux dispositions décrites ci-dessus, un signal de synchronisation en provenance des moyens de synchronisation bloque et débloque les composants de mesure en alternance, le composant de mesure activé ne subissant donc plus l'influence du composant de mesure bloqué pendant la mesure.

La présente invention concerne également un clavier tactile matricé comprenant deux ensembles d'électrodes pour former les lignes et les colonnes de la matrice de touche et un dispositif ou un système décrit précédemment dans lequel les signaux d'entrée proviennent des électrodes.

La présence de multiples électrodes à proximité les unes des autres occasionne la création d'un couplage capacitif, notamment entre entre les électrode des lignes et des colonnes, qui sont en général positionnées en deux couches situées à proximité l'une de l'autre.

Avantageusement, les moyens de synchronisation bloquent alternativement les premiers composants reliés à certaines électrodes du clavier, en permettant le fonctionnement d'autres premiers composants reliés aux autres électrodes du clavier.

De préférence, les moyens de synchronisation commandent à la fois un blocage d'un premier composant, et la liaison de l'électrode correspondante à la masse.

De toute façon, l'invention sera bien comprise à l'aide de la description qui suit, en référence au dessin schématique annexé représentant, à titre d'exemple non limitatif, de deux formes d'exécution de ce dispositif électronique.
La figure 1 est un schéma de principe d'un premier dispositif selon l'invention.
La figure 2 est une vue schématique d'un clavier matriciel selon l'invention.
La figure 3 représente l'évolution dans le temps du signal de sortie du comparaison de phase et du signal dérivé de ce signal de sortie.
La figure 4 est une courbe représentant le signal dérivé du signal de sortie du composant de comparaison en boucle ouverte.
La figure 5 est un schéma électrique pour le dispositif de figure 1;
La figure 6 est un schéma de principe d'un second dispositif selon l'invention.
La figure 7 est un schéma électrique d'un second dispositif selon l'invention.
La figure 8 est un schéma de principe d'un troisième dispositif selon l'invention.
La figure 9 est un schéma de principe d'un dispositif selon l'invention comprenant plusieurs capteurs reliés à un même oscillateur.
La figure 10 est un schéma de principe dispositif selon l'invention comprenant plusieurs capteurs et plusieurs premiers oscillateurs.
La figure 11 est un schéma de principe d'un dispositif selon l'invention destiné à une utilisation comme récepteur de communication avec démodulateur FM.
La figure 12 représente l'évolution dans le temps du signal de sortie du comparaison de phase pour un dispositif traitant plusieurs signaux d'entrée.

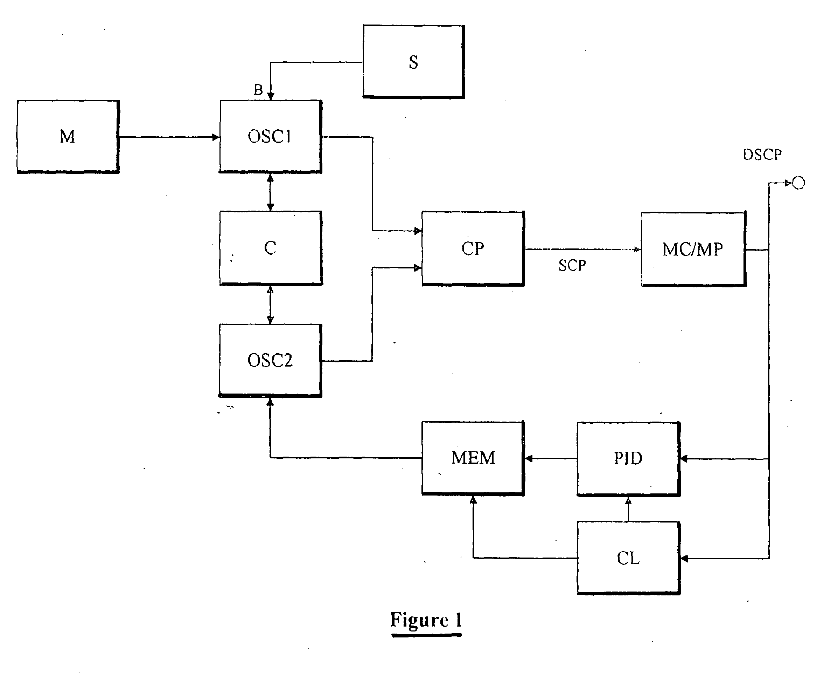

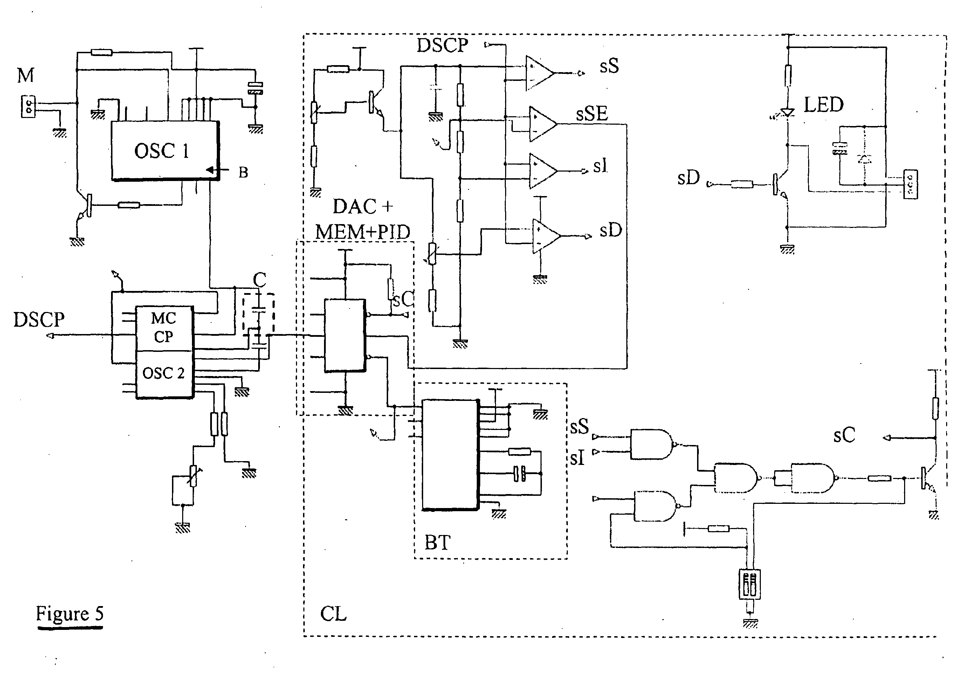

Selon un premier mode de réalisation, représenté sur les figures 1 et 5, un dispositif selon l'invention comporte un premier oscillateur OSC 1 relié à un capteur physique M. Le capteur M détermine la fréquence nominale du premier oscillateur OSC1. Celui-ci retourne en sortie un signal oscillant.

Le premier oscillateur OSC1 dispose d'une entrée de blocage B pilotée par un composant de synchronisation S.

Le premier oscillateur OSC1 est couplé à un second oscillateur OSC2 par un composant de couplage C. Il s'agit d'un couplage dit élastique.

Avantageusement, Le couplage entre le premier et le second oscillateur est un couplage asymétrique, de façon à ce que le premier oscillateur OSC1 influence le second oscillateur OSC2.

L'asymétrie est réalisée par le fait que le composant de couplage est relié au premier oscillateur OSC1 par une sortie de faible impédance et au second oscillateur OSC2 par une entrée de forte impédance.

La sortie du premier oscillateur est amenée sur une première entrée d'un composant de comparaison de phase CP, la sortie du second oscillateur OSC2 étant amenée sur sa seconde entrée.

En sortie du composant de comparaison de phase CP, on obtient un signal SCP représentatif de la différence de phase entre les signaux d'entrée.

En sortie du CP est disposé un composant de mesure de Crête ou de Mesure de Pente MC/MP.

Le signal de sortie DSCP du composant de mesure de crête ou de pente MC/MP fournit alors une information reflétant les variations de la grandeur physique à mesurer.

La sortie du composant de mesure de crête ou de mesure de pente MC/MP est reliée à un composant de commande du second oscillateur OSC2, réalisant par exemple une commande de type Proportionnelle, Intégrale, Dérivée (PID), ou encore une simple commande d'intégration.

Un composant intermédiaire de mémorisation MEM de la consigne de commande est positionné entre la sortie du composant de commande et le second oscillateur.

Une logique de contrôle CL permet de contrôler l'utilisation du composant de commande PID et de la mémoire MEM comme nous le verrons ci-dessous.

La logique de contrôle CL peut être réalisée en logique câblée ou avantageusement basée sur un microcontrôleur qui peut inclure tout ou partie des composants de commande PID, de Mémoire MEM, de comparaison de phase CP, de l'oscillateur de référence OSC2 et de synchronisation S.

On s'intéressera à présent au fonctionnement du dispositif décrit à la figure 1.

Dans un premier mode de fonctionnement dit de calibrage, la sortie du composant de mesure de Crête ou de Mesure de Pente MC/MP est relié par une boucle au second oscillateur OSC2, en appliquant une consigne de correction avec une constante de temps faible. Ainsi, la fréquence nominale d'oscillation du second oscillateur OSC2 est rapidement ramenée au niveau de celle du premier oscillateur OSC1, de sorte que le point de fonctionnement nominal du régime établi puisse être obtenu et stabilisé.

Dans un second mode de fonctionnement, dit de compensation, la sortie du composant de mesure de Crête ou de Mesure de Pente MC/MP est relié par une boucle au second oscillateur OSC2, en appliquant une consigne de correction avec une constante de temps importante, supérieure à la constante de temps utilisée en mode de calibrage.

Dans ce cas, la constante de temps est d'ordre de grandeur supérieur à celui des variations de la grandeur physique à mesurer et inférieur à celui de la dérive du signal représentant cette grandeur physique.

Ainsi, dans le second mode de fonctionnement, la fréquence d'oscillation nominale du second oscillateur OSC2 peut être ramenée progressivement à la fréquence nominale du premier oscillateur OSC1, de manière à compenser les variations lentes et/ou les dérives.

Les variations rapides de la grandeur physique à mesurer ne sont pas affectées par une compensation plus lente et progressive telle que celle apparaissant lors du second mode de fonctionnement. De cette manière, le phénomène de compensation n'a pas d'effet sur la mesure réalisée par le dispositif selon l'invention.

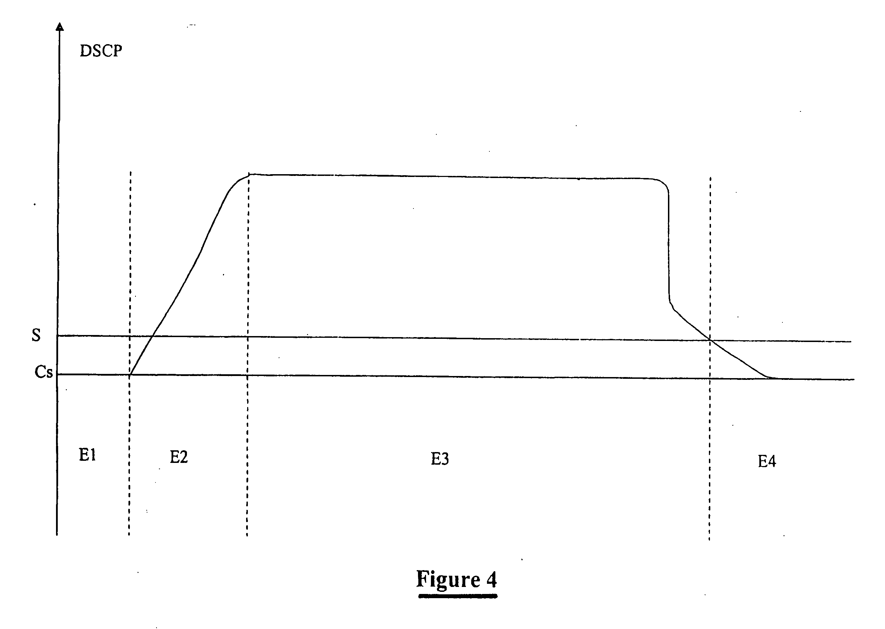

La compensation peut également être supprimée temporairement comme nous allons le décrire ci-dessous en référence à la figure 4.

En E1, La valeur du signal de sortie DSCP composant de mesure de Crête ou de Mesure de Pente MC/MP ou la pente due à la variation de cette valeur est comparée à des seuils de référence S. Par exemple, tant que la valeur du signal DSCP est comprise entre la valeur de la consigne Cs et le seuil S, la boucle entre la sortie du composant de mesure de Crête ou de Mesure de Pente MC/MP et le second oscillateur OSC2 reste fermée.

La boucle entre la sortie du composant de mesure de Crête ou de Mesure de Pente MC/MP et le second oscillateur OSC2 est ouverte en E2 si la valeur du signal de sortie du composant de mesure de Crête ou de Mesure de Pente MC/MP ou la pente due à la variation de cette valeur est supérieure à un premier seuil déterminé, cette boucle étant à nouveau fermée en E4 si la valeur la valeur du signal de sortie du composant de mesure de Crête ou de Mesure de Pente MC/MP ou la pente due à la variation de cette valeur est inférieure à un second seuil déterminé.

Lorsque la boucle est ouverte, le point de fonctionnement du second oscillateur OSC2 est maintenu par l'intermédiaire de la mémoire MEM. Par le terme mémoire, il faut entendre tout composant permettant de réaliser la fonction de maintien du point de fonctionnement.

Un tel découplage de l'asservissement permet d'éviter les phénomènes de surcompensation.

La mesure est alors réalisée pendant la durée de l'événement physique délimitée par les premier et second seuils.

Un tel évènement peut par exemple être la détection d'une personne marchant sur un capteur de pression.

Un premier front lors duquel le premier seuil est dépassé apparaît lorsque le pied est appuyé sur le capteur, un second front lors duquel le second seuil est dépassé apparaissant lorsque le pied est retiré du capteur.

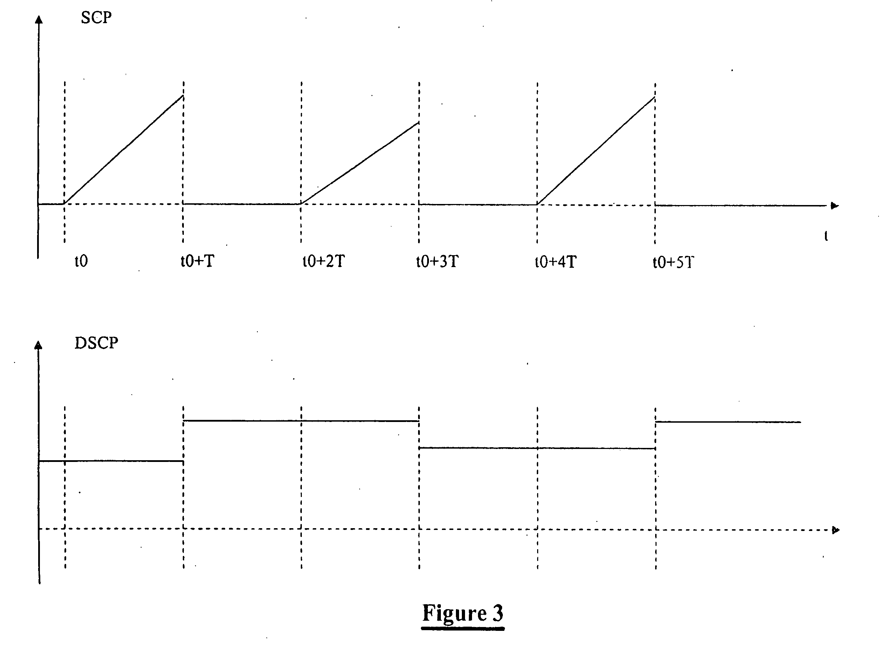

Le fonctionnement du dispositif avec les moyens de synchronisation S est à présent décrit en référence à la figure 3.

Les moyens de synchronisation S bloquent le premier composant, c'est-à-dire l'oscillateur OSC1, pendant des intervalles de temps déterminés, et permettent son oscillation pendant d'autres intervalles de temps.

A chaque fois que l'oscillateur OSC1 est bloqué, le signal de sortie du composant de comparaison SCP est saturé car seules les oscillations de l'oscillateur commandé OSC2 parviennent au comparateur de phase CP. L'oscillateur OSC1 a une fréquence « nulle ».

A chaque fois que l'oscillateur OSC1 entre à nouveau en oscillation, le signal de sortie du composant de comparaison SCP rejoint progressivement sa valeur nominale, c'est à dire celle du régime établi si l'oscillateur OSC1 n'avait pas été bloqué.

La variation de la grandeur physique à mesurer est donnée par la pente du signal de sortie du composant de comparaison de phase durant la phase de déblocage du premier composant.

Si les moyens de synchronisation réalisent des blocages à fréquence fixe, les moyens de détermination du signal dérivé peuvent être constitués par un composant de mesure de crête du signal à la fin d'une période de déblocage. Avantageusement, la valeur de crête du signal à la fin d'une période de déblocage peut être maintenue par le composant jusqu'à la fin de la période suivante, lorsqu'une nouvelle valeur de crête est déterminée.

Il est à noter que les périodes de blocage et d'oscillation sont représentées avec une même durée T sur la figure 3. Toutefois, il est bien entendu possible de réduire ces durées soient différentes, et en particulier que la durée d'un blocage soit inférieure à une période d'oscillation.

Le schéma électronique du dispositif de figure 1 est représenté sur la figure 5.

On retrouve sur ce schéma les divers composants du dispositif électronique.

Le capteur de mesure M est relié au premier oscillateur OSC 1, lui-même couplé à un second oscillateur OSC 2. Le couplage élastique C est réalisé ici par l'intermédiaire d'un condensateur.

On remarque que le composant ayant la fonction du second oscillateur 2 a également la fonction du composant de comparaison de phase CP et de mesure de crête MC. La sortie de ce dernier, notée DSCP, est utilisée par la logique de contrôle CL, réalisée ici en logique câblée.

Ce signal de sortie DSCP du composant de mesure de crête est ensuite traité par l'intermédiaire de comparateurs. Ces comparateurs permettent d'obtenir un signal de dépassement d'un seuil supérieur sS, un signal de dépassement d'un seuil inférieur sI, un signal correspondant au sens de l'erreur à compenser sSE et un signal de détection sD.

Le signal de détection sD peut par exemple être utilisé pour alimenter une LED afin de réaliser une interface avec un opérateur.

Les signaux de dépassement des seuils supérieur sS ou inférieur sI sont traités par l'intermédiaire d'éléments logiques de manière à obtenir un signal de commande sC. Ce signal sC permet de commander le composant réalisant à la fois la fonction de convertisseur numérique-analogique, d'intégrateur et de mémoire, qui est dans ce cas un potentiomètre électronique, de manière à obtenir soit un asservissement du second oscillateur OSC2 par le composant de mesure de Crête MC, soit un fonctionnement en boucle ouverte, sans asservissement du second oscillateur OSC 2 et avec utilisation de la mémoire MEM.

Enfin, un composant BT permettant d'assurer la fonction de base de temps est relié directement au convertisseur numérique-analogique DAC, ce composant permettant de réguler la constante de temps de la compensation.

Le convertisseur réalise également la commande, il n'y a donc pas de composant de commande de type PID séparé.

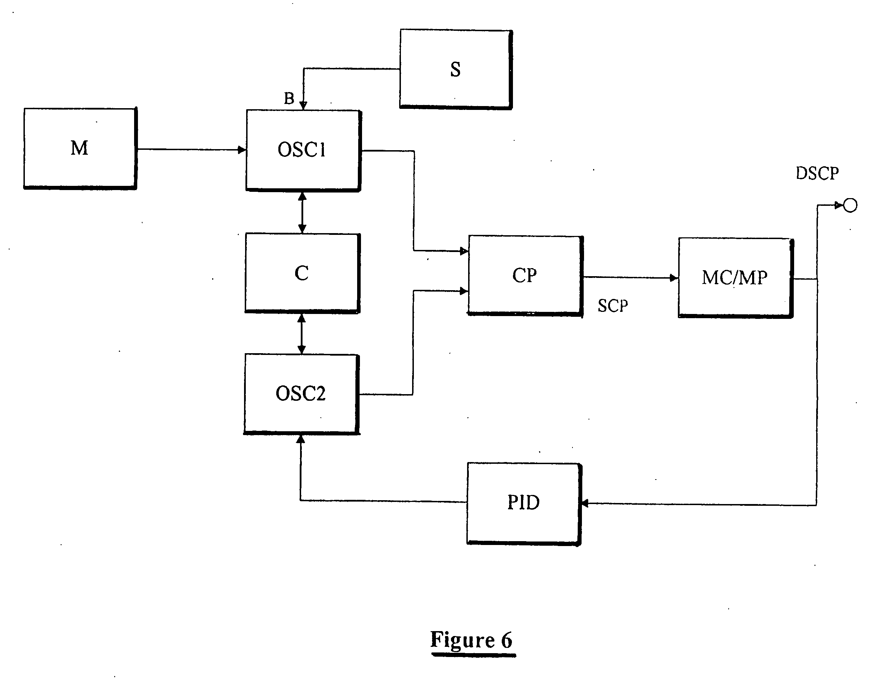

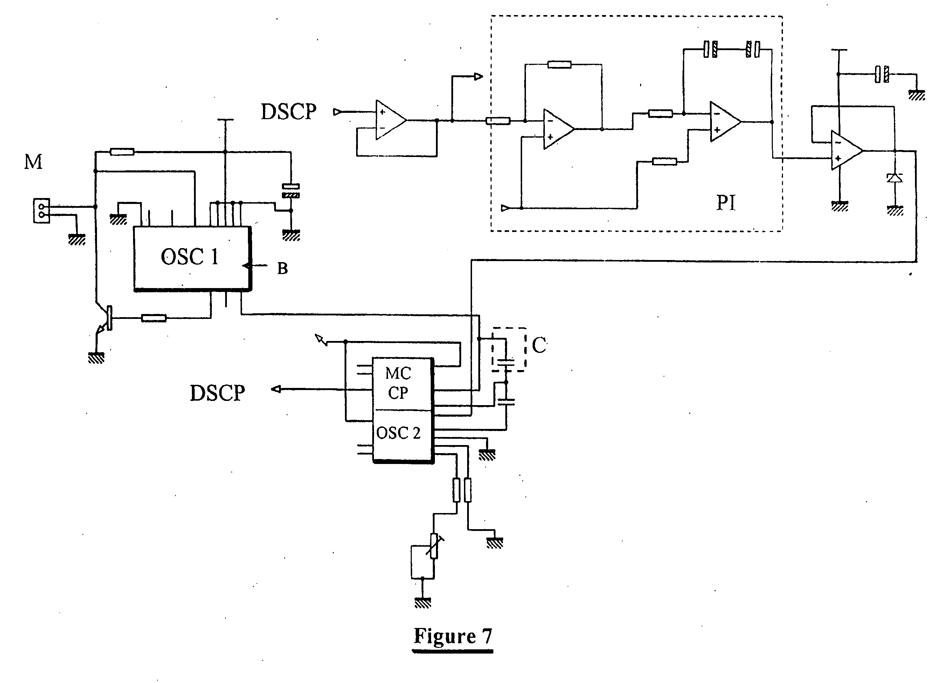

Selon un second mode de réalisation représenté sur les figures 6 et 7, le dispositif n'utilise pas de logique de commande, et ne comprend pas de composant de mémorisation.

Comme pour le précédent circuit, le capteur de mesure M est raccordé au premier oscillateur OSC 1, lui-même couplé à un second oscillateur OSC 2 par un condensateur C.

Le composant ayant la fonction du second oscillateur 2 a également la fonction du composant de comparaison de phase CP et de mesure de crête MC. La sortie de ce dernier, notée DSCP, est utilisée par un composant de commande Proportionnel Intégral PI pour générer de façon analogique une consigne pour le second oscillateur OSC2.

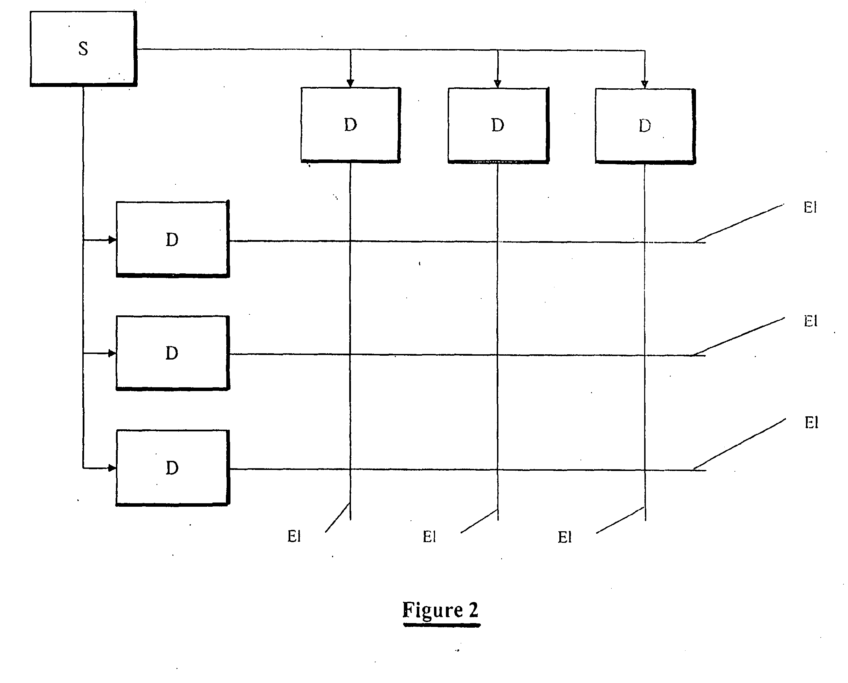

Ainsi que représenté sur la figure 2, plusieurs dispositifs D peuvent être assemblés en un système, les dispositifs partageant les moyens de synchronisation S. Ce système peut notamment être utilisé dans un clavier matriciel comme représenté sur la figure 2.

Un clavier matricé comprend des lignes et des colonnes aux intersections desquelles sont matérialisés les emplacement des touches. Chaque ligne et chaque colonne comprend une électrode EI, les électrodes des lignes et des colonnes formant deux couches superposées à faible distance l'une de l'autre. On mesure la capacité entre chaque électrode et la masse. Pour chaque dispositif D, l'électrode EI constitue une partie du capteur de mesure M.

La proximité d'un doigt par exemple au niveau de l'emplacement d'une touche occasionne :
- une variation de capacité entre une électrode de ligne et la masse, et
- une variation de capacité entre une électrode de colonne et la masse

La détection de la variation de ces deux capacités permet d'identifier la proximité d'un doigt avec la touche se situant à l'intersection de la ligne et de la colonne.

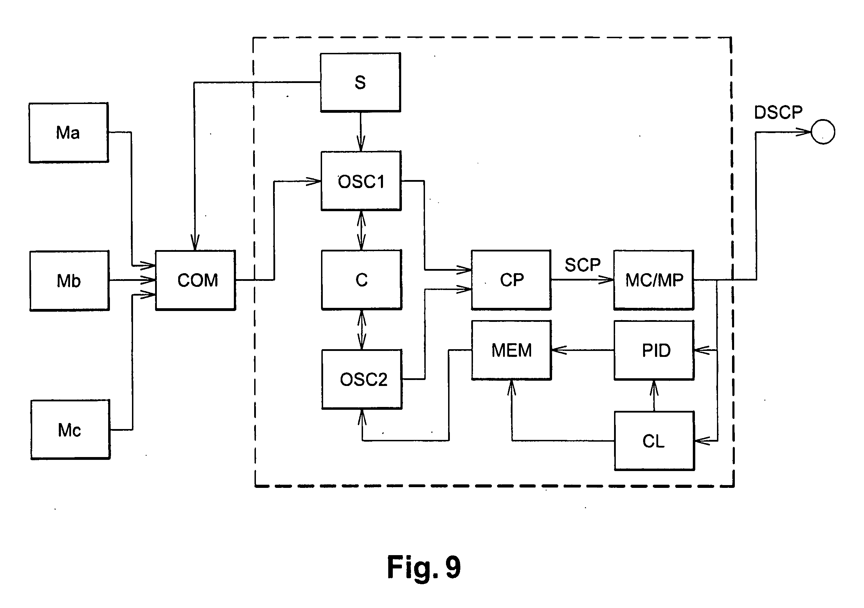

Selon un troisième mode de réalisation représenté sur la figure 9, au lieu d'utiliser un système comprenant un ensemble de dispositifs selon les premier ou second mode de réalisation, il est également possible de réaliser un dispositif unique exploitant le signal provenant de plusieurs capteurs Ma, Mb, Mc.

Ainsi, le dispositif comprend un ensemble de capteurs Ma, Mb, Mc reliées par un composant COM qui réalise une commutation de la connexion entre chaque capteur et un unique premier oscillateur OSC1. Le premier oscillateur est relié en aval aux composants tels que décrits en référence à la figure 1.

Les capteurs peuvent par exemple être constitués par des électrodes, comme celle utilisées dans le clavier décrit en référence à la figure 2.

La commutation des capteurs par le composant de commutation COM est commandée par un composant de synchronisation S tel que décrit précédemment.

Ces dispositions permettent une mise en commun de la plupart des composants et donc une simplification du système.

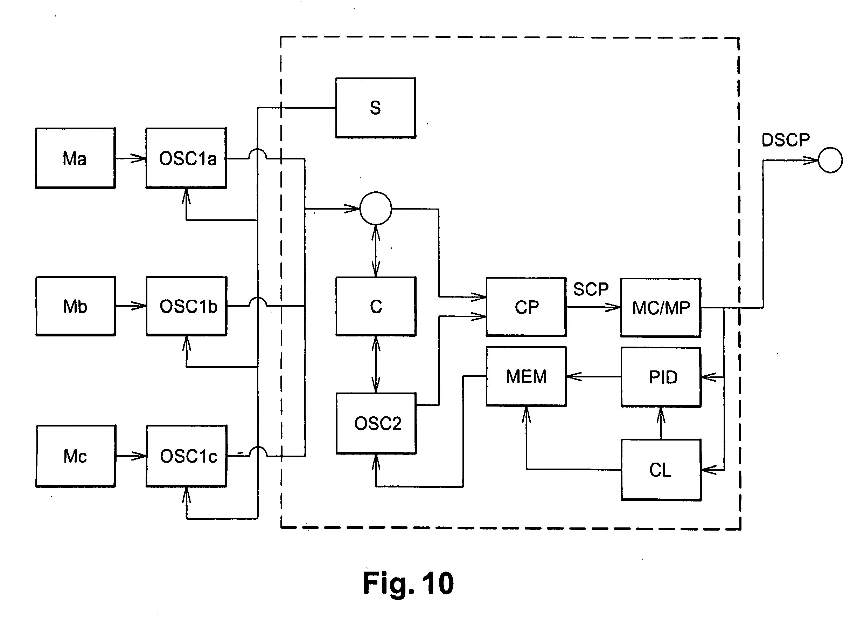

Selon un quatrième mode de réalisation représenté sur la figure 10, le dispositif comprend un premier oscillateur OSC1 a, OSC1b, OSC1c pour chaque capteur Ma, Mb, Mc, chaque oscillateur étant bloqué ou débloqué selon la phase de fonctionnement.

En aval des oscillateurs OSC1a, OSC1b, OSC1c, ceux-ci sont reliés à un ensemble de commun de composants correspondant à ceux décrits en référence à la figure 1.

Ces dispositions permettent d'éviter d'ajouter des composantes parasites supplémentaires entre le capteur et l'oscillateur, qui pourrait être occasionnées par la présence d'un élément de commutation.

Ces dispositions permettent en outre de déporter l'ensemble constitué du capteur et de l'oscillateur à distance du reste du dispositif, en utilisant entre l'oscillateur et le reste du dispositif une liaison à distance. Cette liaison à distance peut être de tout type, par exemple optique, radiofréquence, ultrasonore ou par un réseau informatique.

Ces dispositions permettent également de traiter des signaux hétérogènes, par exemple des grandeurs physiques hétérogènes avec un même système. Par exemple, il est possible d'envisager de traiter des grandeurs capactive, inductive et ultrason dans le même dispositif.

Dans la configuration des troisième et quatrième modes de réalisation dans lesquels plusieurs signaux d'entrée sont traités par un même dispositif, les moyens de synchronisation sont conçus pour réaliser successivement :
- une sélection d'un premier signal d'entrée à traiter, provenant d'un premier capteur Ma pendant une première période de temps de traitement T1, pendant laquelle le signal de sortie du premier composant influence les moyens de couplage C et de comparaison de phase CP, puis
- un blocage de l'influence de tout signal d'entrée sur le composant de comparaison de phase pendant une période de temps de blocage B suivant la première période de temps, de façon à ce que signal de sortie du composant de comparaison de phase revienne à une position de repos, puis
- une nouvelle sélection d'un second signal d'entrée à traiter, provenant d'un second capteur Mb pendant une seconde période de temps de traitement T2, pendant laquelle le signal de sortie du premier composant influence les moyens de couplage C et de comparaison de phase CP, puis
- une seconde période de blocage est observée.

L'alternance des phases d'oscillation T1, T2 et de blocage est réalisée en boucle de façon à ce que chacun des signaux d'entrée soit traité et à obtenir un multiplexage des signaux d'entrée.

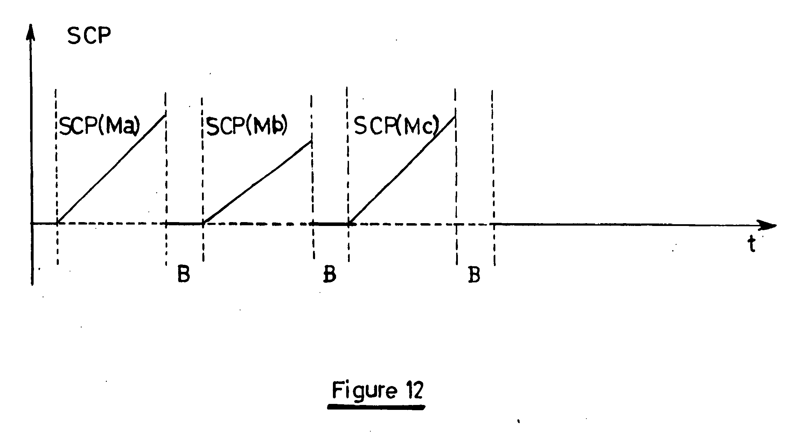

Un exemple de l'évolution du signal de sortie SCP du composant de comparaison de phase CP correspondant au multiplexage décrit ci-dessus est représenté sur la figure 12.

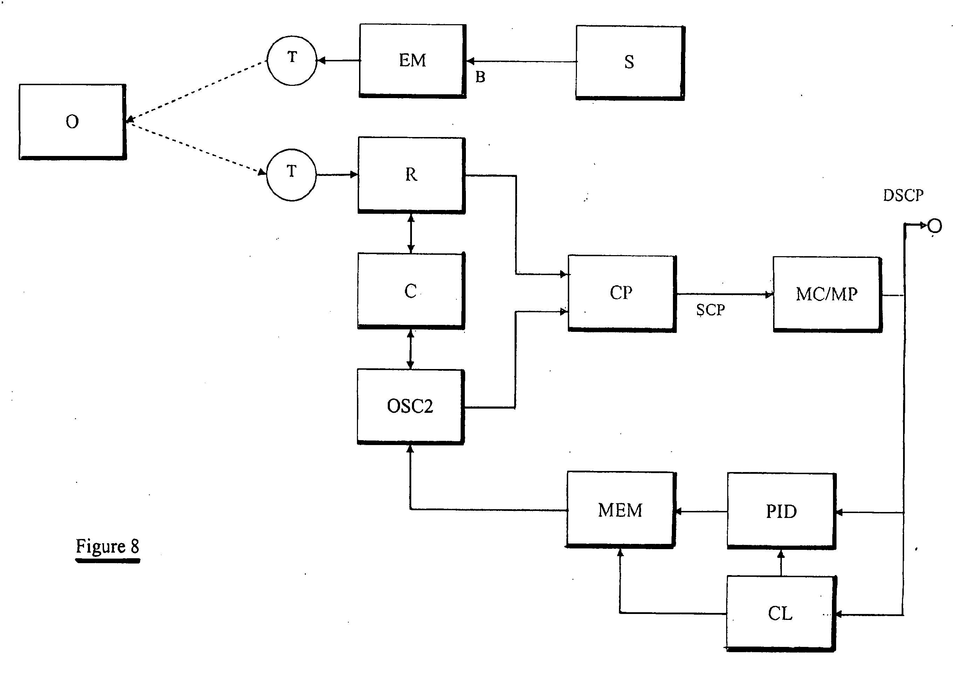

Selon un cinquième mode de réalisation, dont le schéma de principe est représenté sur la figure 8, le dispositif est destiné à mesurer non plus un signal oscillatoire provenant d'un oscillateur relié à un capteur, mais un signal oscillatoire provenant, ou renvoyé par un élément extérieur au dispositif et capté par un récepteur approprié.

Ce mode de réalisation trouve son application par exemple pour déterminer la vitesse d'un objet O en déplacement par effet Doppler-Fizeau, et pour réaliser un capteur de mouvement dans l'air, utilisant par exemple une fréquence de fonctionnement entre 40 et 200 KHz

Pour cela, il convient d'utiliser un émetteur EM destiné à produire un signal émis à une fréquence donnée, par exemple 40 KHz, qui est produite en direction de l'objet par un Transducteur T, puis, après réflexion sur l'objet, de capter le signal réfléchi par un autre transducteur T relié à un récepteur R permettant de réaliser une amplification et une mise en forme du signal. Le signal en sortie du récepteur R est traité par la suite comme précédemment le signal du premier oscillateur, le dispositif reprenant les mêmes éléments que dans le premier mode de réalisation.

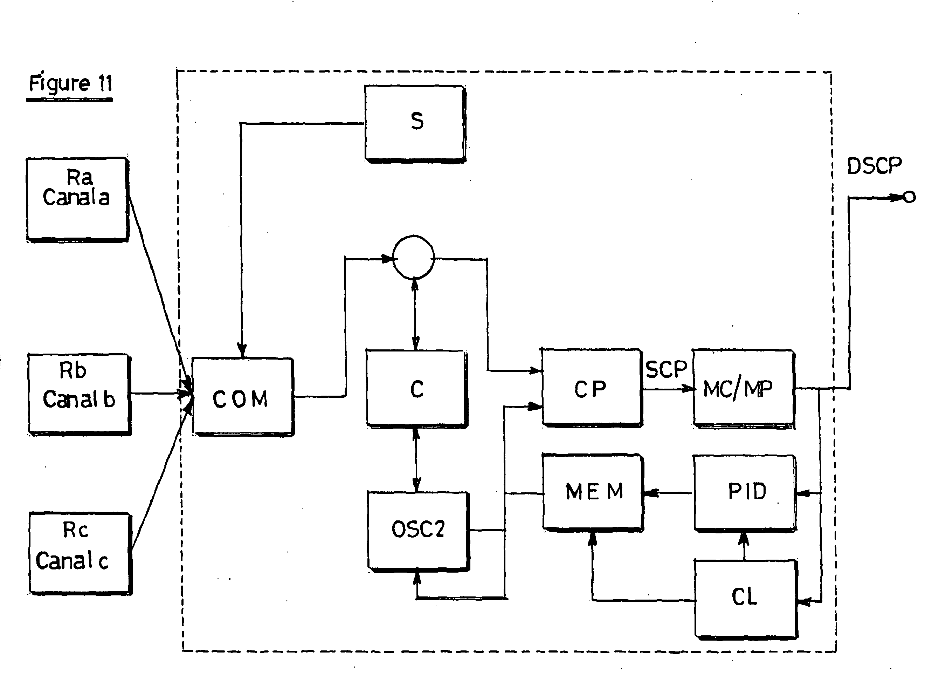

Selon un sixième mode de réalisation représenté sur la figure 11, le dispositif est utilisé dans un système de communication avec modulation de fréquence.

Dans ce cas, il ne s'agit pas directement de mesurer une grandeur physique, mais de démoduler des signaux reçus sur différents canaux et modulés en fréquence.

Des composants de réception constitués par des antennes de réceptions Ra, Rb, Rc sur les différents canaux reçoivent des signaux d'entrée. Ces composants de réception sont reliés à un composant de commutation, commandé par les moyens de synchronisation afin de réaliser une sélection du canal sur lequel le signal doit être reçu, et de pouvoir inhiber la réception de tout signal.

L'utilisation du couplage C, du comparateur de phase CPF, et des moyens de détermination MP/MC d'un signal dérivé permettent de réaliser une démodulation du signal pour une utilisation ultérieure de ce signal.

La démodulation par le dispositif selon l'invention confère une très grande sensibilité permettant d'utiliser des plages de modulation étroites pour chaque canal de communication.

En outre, il est possible d'asservir la réception de chaque canal sur une fréquence centrale F0 pouvant être soumise à des dérives. En effet, l'effet de compensation des dérives mis en évidence précédemment pour la mesure des grandeurs physique est également présent dans ce mode de réalisation.

Il est à noter que le support physique de communication peut être de tout type, par exemple filaire, radiofréquence, optique, ultrasonore.

Il est possible d'utiliser plusieurs supports distincts comme cela a été décrit avec les capteurs de grandeurs physiques. L'intérêt est de permettre une redondance par différentes voies de communications.

Selon une variante, on peut prévoir d'ajouter au circuit un diviseur de fréquence dont le rapport de division est ajustable, entre le premier composant et l'oscillateur.

Ce diviseur de fréquence DIV%N permet de choisir la gamme de fonctionnement du dispositif.

Selon une autre variante, un autre type de composants de commande peut être utilisé, par exemple un composant réalisant une commande par logique floue.

Les applications principales du dispositif selon l'invention se divisent en trois catégories, la liste des applications citées ci-dessous n'étant pas exhaustive. La première catégorie concerne les interfaces homme machine tactiles utilisant un principe de fonctionnement de type électrostatique ou inductif. On peut citer notamment un clavier ou un écran tactile capacitif utilisant une détection capacitive projetée, en plus du clavier tel que décrit en référence à la figure 2.

La seconde catégorie est celle du conditionnement de signal d'une grandeur physique à mesurer. Cette grandeur physique peut être de nature capacitive, inductive, thermique, ultrason ou encore un signal utilisé dans l'identification radiofréquence (RFID).

En ce qui concerne le conditionnement d'un signal provenant d'un capteur, celui-ci est applicable en particulier à :
- un capteur capacitif d'approche détectant une perturbation du champ électrostatique à une distance inférieure au mètre,
- un capteur de proximité de type capacitif détectant une perturbation du champ électrostatique à une distance de quelques centimètres ou de type inductif détectant des courants de Foucault,
- un détecteur de métaux fonctionnant par détection des courants de Foucault,
- un capteur de force ou de pression de type capacitif utilisant des électrodes et des isolants stratifié ou de type inductif utilisant la déformation ou
   le déplacement d'un corps d'épreuve,
- un accéléromètre de type capacitif ou inductif utilisant la déformation ou le déplacement d'un corps d'épreuve,
- un capteur chimique de type capacitif utilisant la modification du milieu diélectrique,
- un débitmètre pour fluides de type thermique utilisant la différence de température entre deux composants,
- un capteur de mouvement utilisant les hyperfréquences ou les ultrasons et l'effet Doppler/Fizeau tel que décrit précédemment,
- un capteur de contrôle de l'intégrité d'une surface ou d'une paroi de type capacitif utilisant la déformation d'électrodes et/ou un changement du diélectrique,

Dans le cas de la communication RFID, le dispositif est utilisé comme conditionneur de signal d'un capteur électromagnétique.

La troisième catégorie concerne le conditionnement de signaux dans le domaine des communications, en particulier illustré par le mode de réalisation décrit en référence à la figure 11.

Comme il va de soi, l'invention ne se limite pas à la seule forme d'exécution de ce dispositif électronique, décrite ci-dessus à titre d'exemple, mais elle embrasse au contraire toutes les variantes.

## Revendications

1. Dispositif électronique, destiné à réaliser la mesure et la détection de variations d'au moins un signal d'entrée, comportant :
- un premier composant (OSC1, R) fournissant un signal de sortie dont la fréquence d'oscillation est représentative du signal d'entrée,
- un oscillateur de référence (OSC2),
- un composant de comparaison de phase (CP) réalisant une comparaison entre les oscillations du premier composant (OSC1) et de l'oscillateur de référence (OSC2), notamment en vue d'un asservissement par une boucle de l'oscillateur de référence sur le premier composant, ou du premier composant sur l'oscillateur de référence, ou d'un asservissement mutuel, et
- des moyens de couplage élastiques (C) entre le premier composant (OSC1) et l'oscillateur de référence (OSC2),
**caractérisé en ce qu'**il comprend
des moyens de synchronisation (S) conçus pour bloquer ou autoriser alternativement l'influence des oscillations du premier composant (OSC1, R) sur le composant de comparaison de phase (CP) et sur les moyens de couplage (C), et des moyens de détermination (MP/MC) d'un signal dérivé (DSCP) de l'évolution du signal de sortie du composant de comparaison de phase (SCP).

2. Dispositif selon la revendication 1, dans lequel les moyens de couplage élastiques (C) sont conçus pour réaliser un couplage asymétrique de façon à ce que l'influence du premier composant (OSC1) sur l'oscillateur de référence (OSC2) soit supérieure à l'influence de l'oscillateur de référence (OSC2) sur le premier composant (OSC1).

3. Dispositif selon la revendication 2, dans lequel les moyens de couplage élastiques (C) sont conçus pour réaliser un couplage unidirectionnel de façon à ce que le premier composant (OSC1) influence l'oscillateur de référence (OSC2).

4. Dispositif selon l'une des revendications précédentes, dans lequel les moyens de détermination d'un signal dérivé (DSCP) de l'évolution du signal de sortie du composant de comparaison de phase (SCP) comprennent un composant de mesure de pente (MP) du signal de sortie du composant de comparaison de phase (CP).

5. Dispositif selon l'une des revendications 1 à 4, dans lequel les moyens de synchronisation réalisent des blocages à fréquence fixe, et dans lequel les moyens de détermination d'un signal dérivé (DSCP) de l'évolution du signal de sortie du composant de comparaison de phase (SCP) comprennent un composant de mesure de crête (MC) du signal à la fin d'une période de déblocage.

6. Dispositif selon l'une des revendications précédentes, dans lequel le premier composant est un oscillateur (OSC1) relié à un capteur de mesure (M) d'une grandeur physique à mesurer.

7. Dispositif selon l'une des revendications 1 à 5, dans lequel le premier composant est un récepteur d'un signal extérieur au dispositif (R).

8. Dispositif selon la revendication 7, dans lequel le récepteur est conçu pour recevoir un signal de communication en modulation de fréquence.

9. Dispositif selon l'une des revendications précédentes, comportant un composant de commande (PID) de l'asservissement de l'oscillateur de référence (OSC2) ou du premier composant (OSC1, R).

10. Dispositif selon l'une des revendications précédentes, comprenant un composant de mémorisation (MEM), permettant de maintenir, selon un mode de fonctionnement, une tension de consigne constante pour la commande de l'oscillateur de référence (OSC2) ou du premier composant (OSC1, R) pendant une durée déterminée.

11. Dispositif selon l'une des revendications précédentes, dans lequel, dans un mode de fonctionnement, les moyens de détermination (MP/MC) d'un signal dérivé (DSCP) sont reliés par une boucle à l'oscillateur de référence (OSC2) ou au premier composant (OSC1, R) pour appliquer une consigne de correction avec une constante de temps dont l'ordre de grandeur est supérieur à celui des variations de la grandeur physique à mesurer et inférieure à celui de la dérive du signal représentant cette grandeur physique.

12. Dispositif selon la revendication 11, dans lequel la constante de temps peut être réglée à une première valeur dans un mode de calibration et à une seconde valeur, supérieure à la première, dans un mode de compensation.

13. Dispositif selon la revendication 10, dans lequel, dans un mode de fonctionnement, le bouclage entre la sortie des moyens de détermination (MP/MC) d'un signal dérivé (DSCP) et l'oscillateur de référence (OSC2) ou le premier composant (OSC1, R) est supprimé, le point de fonctionnement étant maintenu par le composant de mémorisation (MEM).

14. Dispositif selon la revendication 13, dans lequel, dans un mode de fonctionnement, le bouclage entre la sortie des moyens de détermination (MP/MC) d'un signal dérivé (DSCP) et l'oscillateur de référence (OSC2) ou le premier composant (OSC1, R) est supprimé si la valeur du signal dérivé (DSCP) ou la pente due à la variation de cette valeur est supérieure à un premier seuil déterminé, les moyens de détermination (MP/MC) d'un signal dérivé (DSCP) étant à nouveau reliés par une boucle à l'oscillateur de référence (OSC2) ou au premier composant (OSC1, R) si la valeur du signal dérivé (DSCP) ou la pente due à la variation de cette valeur est inférieure à un second seuil déterminé.

15. Dispositif selon l'une des revendications précédente, destiné à réaliser la mesure et la détection de variations d'au moins deux signaux d'entrée, les moyens de synchronisation (S) permettant de traiter sélectivement l'un des signaux d'entrée.

16. Dispositif selon la revendication 15 et selon la revendication 6, comprenant au moins deux capteurs de mesure (Ma, Mb, Mc) et des moyens de commutation permettant commandés par les moyens de synchronisation pour traiter sélectivement le signal provenant de l'un des capteurs de mesure, un oscillateur unique (OSC1) étant situé en aval des moyens de commutation, cet oscillateur pouvant être bloqué par les moyens de synchronisation (S).

17. Dispositif selon la revendication 15 et selon la revendication 6, comprenant au moins deux capteurs de mesure (Ma, Mb, Mc) et un oscillateur (OSC1a, OSC1b, OSC1c) associé à en aval de chacun des capteurs de mesure (Ma, Mb, Mc), les moyens de synchronisation (S) étant conçus pour sélectionner la sortie d'un oscillateur à traiter et pour bloquer la sortie de ces oscillateurs.

18. Système comprenant au moins deux dispositifs selon l'une des revendications précédentes, dans lequel des moyens de synchronisation communs (S) permettent de bloquer alternativement les oscillations du premier composant des différents dispositifs du système.

19. Clavier tactile matricé comprenant deux ensembles d'électrodes (El) pour former les lignes et les colonnes de la matrice de touche et un dispositif selon l'une des revendications 15 à 17 ou un système selon la revendication 18, dans lequel, les signaux d'entrée proviennent des électrodes (EI).

20. Clavier selon la revendication 19, dans lesquels les moyens de synchronisation (S) bloquent alternativement les premiers composants (M, OSC1) reliés à certaines électrodes (El) du clavier, en permettant le fonctionnement d'autres premiers composants (M, OSC1) reliés aux autres électrodes (El) du clavier.

21. Clavier selon l'une des revendications 19 ou 20, dans lequel les moyens de synchronisation (S) commandent à la fois un blocage d'un premier composant (M, OSC1), et la liaison de l'électrode (EI) correspondante à la masse.

## Claims

1. Electronic device, intended to carry out the measurement and the detection of variations of at least one input signal, comprising:
- a first component (OSC1, R) providing an output signal whose oscillation frequency is representative of the input signal,
- a reference oscillator (OSC2),
- a phase comparison component (PC) carrying out a comparison between the oscillations of the first component (OSC1) and of the reference oscillator (OSC2), in particular for the purpose of a slaving by a loop of the reference oscillator to the first component, or of the first component to the reference oscillator, or of a mutual slaving, and
- elastic means of coupling (C) between the first component (OSC1) and the reference oscillator (OSC2),
**characterized in that** it comprises synchronization means (S) designed to alternately block or permit the influence of the oscillations of the first component (OSC1, R) on the phase comparison component (CP) and on the coupling means (C), and means (SM/PM) for determining a derived signal (DSCP) from the evolution of the output signal from the phase comparison component (SCP).

2. Device according to Claim 1, in which the elastic coupling means (C) are designed to carry out an asymmetric coupling in such a way that the influence of the first component (OSC1) on the reference oscillator (OSC2) is greater than the influence of the reference oscillator (OSC2) on the first component (OSC1).

3. Device according to Claim 2, in which the elastic coupling means (C) are designed to carry out a unidirectional coupling in such a way that the first component (OSC1) influences the reference oscillator (OSC2).

4. Device according to one of the preceding claims, in which the means for determining a derived signal (DSCP) from the evolution of the output signal from the phase comparison component (SCP) comprise a component (SM) for measuring the slope of the output signal from the phase comparison component (PC).

5. Device according to one of Claims 1 to 4, in which the synchronization means carry out blockings at fixed frequency, and in which the means for determining a derived signal (DSCP) from the evolution of the output signal from the phase comparison component (SCP) comprise a component (PM) for measuring the peak of the signal at the end of an unblocking period.

6. Device according to one of the preceding claims, in which the first component is an oscillator (OSC1) linked to a measurement sensor (M) of a physical magnitude to be measured.

7. Device according to one of Claims 1 to 5, in which the first component is a receiver of a signal external to the device (R).

8. Device according to Claim 7, in which the receiver is designed to receive a frequency-modulation communication signal.

9. Device according to one of the preceding claims, comprising a component (PID) for controlling the slaving of the reference oscillator (OSC2) or of the first component (OSC1, R).

10. Device according to one of the preceding claims, comprising a storage component (MEM), making it possible to maintain, according to an operating mode, a constant setpoint voltage for the control of the reference oscillator (OSC2) or of the first component (OSC1, R) for a determined duration.

11. Device according to one of the preceding claims, in which, in an operating mode, the means (SM/PM) for determining a derived signal (DSCP) are linked by a loop to the reference oscillator (OSC2) or to the first component (OSC1, R) so as to apply a correction setpoint with a time constant whose order of magnitude is greater than that of the variations of the physical magnitude to be measured and less than that of the drift of the signal representing this physical magnitude.

12. Device according to Claim 11, in which the time constant can be adjusted to a first value in a calibration mode and to a second value, greater than the first, in a compensation mode.

13. Device according to Claim 10, in which, in an operating mode, the looping between the output of the means (SM/PM) for determining a derived signal (DSCP) and the reference oscillator (OSC2) or the first component (OSC1, R) is eliminated, the operating point being maintained by the storage component (MEM).

14. Device according to Claim 13, in which, in an operating mode, the looping between the output of the means (SM/PM) for determining a derived signal (DSCP) and the reference oscillator (OSC2) or the first component (OSC1, R) is eliminated if the value of the derived signal (DSCP) or the slope due to the variation of this value is greater than a first determined threshold, the means (SM/PM) for determining a derived signal (DSCP) being again linked by a loop to the reference oscillator (OSC2) or to the first component (OSC1, R) if the value of the derived signal (DSCP) or the slope due to the variation of this value is less than a second determined threshold.

15. Device according to one of the preceding claims, intended for carrying out the measurement and detection of variations of at least two input signals, the synchronization means (S) making it possible to selectively process one of the input signals.

16. Device according to Claim 15 and according to Claim 6, comprising at least two measurement sensors (Ma, Mb, Mc) and switching means, controlled by the synchronization means, in order to selectively process the signal originating from one of the measurement sensors, a single oscillator (OSC1) being situated downstream of the switching means, this oscillator being able to be blocked by the synchronization means (S).

17. Device according to Claim 15 and according to Claim 6, comprising at least two measurement sensors (Ma, Mb, Mc) and an associated oscillator (OSC1a, OSC1b, OSC1c) downstream of each of the measurement sensors (Ma, Mb, Mc), the synchronization means (S) being designed to select the output of an oscillator to be processed and to block the output of these oscillators.

18. System comprising at least two devices according to one of the preceding claims, in which common synchronization means (S) make it possible to block alternatively the oscillations of the first component of the various devices of the system.

19. Tactile keyboard array comprising two sets of electrodes (El) for forming the rows and the columns of the key array and a device according to one of Claims 15 to 17 or a system according to Claim 18, in which the input signals originate from the electrodes (E1).

20. Keyboard according to Claim 19, in which the synchronization means (S) block alternatively the first components (M, OSC1) linked to certain electrodes (El) of the keyboard, while allowing the operation of other first components (M, OSC1) linked to the other electrodes (El) of the keyboard.

21. Keyboard according to either of Claims 19 and 20, in which the synchronization means (S) control at one and the same time a blocking of a first component (M, OSC1), and the grounding of the corresponding electrode (El).

## Patentansprüche

1. Elektronische Vorrichtung, die dazu bestimmt ist, die Messung und die Erfassung von Veränderungen mindestens eines Eingangssignals durchzuführen, die Folgendes enthält:
- ein erstes Bauteil (OSC1, R), das ein Ausgangssignal liefert, dessen Schwingungsfrequenz für das Eingangssignal repräsentativ ist,
- einen Bezugsoszillator (OSC2),
- ein Phasenvergleichs-Bauteil (CP), das einen Vergleich zwischen den Schwingungen des ersten Bauteils (OSC1) und des Bezugsoszillators (OSC2) durchführt, insbesondere für eine Schleifenregelung des Bezugsoszillators auf das erste Bauteil, oder des ersten Bauteils auf den Bezugsoszillator, oder für eine gegenseitige Regelung, und
- elastische Kopplungseinrichtungen (C) zwischen dem ersten Bauteil (OSC1) und dem Bezugsoszillator (OSC2), **dadurch gekennzeichnet, dass** sie Folgendes enthält Synchronisationseinrichtungen (S), die konzipiert sind, um alternativ den Einfluss der Schwingungen des ersten Bauteils (OSC1, R) auf das Phasenvergleichs-Bauteil (CP) und auf die Kopplungseinrichtungen (C) zu sperren oder zu erlauben, und Einrichtungen zur Bestimmung (MP/MC) eines von der Entwicklung des Ausgangssignals (SCP) des Phasenvergleichs-Bauteils abgeleiteten Signals (DSCP).

2. Vorrichtung nach Anspruch 1, bei der die elastischen Kopplungseinrichtungen (C) konzipiert sind, um eine asymmetrische Kopplung herzustellen, damit der Einfluss des ersten Bauteils (OSC1) auf den Bezugsoszillator (OSC2) größer ist als der Einfluss des Bezugsoszillators (OSC2) auf das erste Bauteil (OSC1).

3. Vorrichtung nach Anspruch 2, bei der die elastischen Kopplungseinrichtungen (C) konzipiert sind, um eine Einwegkopplung durchzuführen, damit das erste Bauteil (OSC1) den Bezugsoszillator (OSC2) beeinflusst.

4. Vorrichtung nach einem der vorhergehenden Ansprüche, bei der die Einrichtungen zur Bestimmung eines von der Entwicklung des Ausgangssignals (SCP) des Phasenvergleichs-Bauteils abgeleiteten Signals (DSCP) ein Bauteil zur Messung der Flankensteilheit (MP) des Ausgangssignals des Phasenvergleichs-Bauteils (CP) enthalten.

5. Vorrichtung nach einem der Ansprüche 1 bis 4, bei der die Synchronisationseinrichtungen Sperrungen mit fester Frequenz durchführen, und bei der die Einrichtungen zur Bestimmung eines von der Entwicklung des Ausgangssignals (SCP) des Phasenvergleichs-Bauteils abgeleiteten Signals (DSCP) ein Bauteil zur Messung der Spitze (MC) des Signals am Ende einer Entsperrungsperiode enthalten.

6. Vorrichtung nach einem der vorhergehenden Ansprüche, bei der das erste Bauteil ein Oszillator (OSC1) ist, der mit einem Messsensor (M) einer zu messenden physikalischen Größe verbunden ist.

7. Vorrichtung nach einem der Ansprüche 1 bis 5, bei der das erste Bauteil ein Empfänger (R) eines Signals außerhalb der Vorrichtung ist.

8. Vorrichtung nach Anspruch 7, bei der der Empfänger konzipiert ist, um ein frequenzmoduliertes Kommunikationssignal zu empfangen.

9. Vorrichtung nach einem der vorhergehenden Ansprüche, die ein Bauteil (PID) zur Steuerung der Regelung des Bezugsoszillators (OSC2) oder des ersten Bauteils (OSC1, R) aufweist.

10. Vorrichtung nach einem der vorhergehenden Ansprüche, die ein Speicherbauteil (MEM) enthält, das es ermöglicht, gemäß einer Betriebsart eine Sollspannung für die Steuerung des Bezugsoszillators (OSC2) oder des ersten Bauteils (OSC1, R) während einer bestimmten Dauer konstant zu halten.

11. Vorrichtung nach einem der vorhergehenden Ansprüche, bei der in einer Betriebsart die Bestimmungseinrichtungen (MP/MC) eines abgeleiteten Signals (DSCP) über eine Schleife mit dem Bezugsoszillator (OSC2) oder mit dem ersten Bauteil (OSC1, R) verbunden sind, um einen Korrektursollwert mit einer Zeitkonstante anzuwenden, deren Größenordnung größer als diejenige der Veränderungen der zu messenden physikalischen Größe und kleiner als diejenige der Drift des Signals ist, das diese physikalische Größe darstellt.

12. Vorrichtung nach Anspruch 11, bei der die Zeitkonstante in einem Kalibrationsmodus auf einen ersten Wert und in einem Kompensationsmodus auf einen zweiten Wert geregelt werden kann, der größer ist als der erste Wert.

13. Vorrichtung nach Anspruch 10, bei der in einer Betriebsart die Schleifenverbindung zwischen dem Ausgang der Bestimmungseinrichtungen (MP/MC) eines abgeleiteten Signals (DSCP) und dem Bezugsoszillator (OSC2) oder dem ersten Bauteil (OSC1, R) unterdrückt wird, wobei der Arbeitspunkt von dem Speicherbauteil (MEM) aufrechterhalten wird.

14. Vorrichtung nach Anspruch 13, bei der in einer Betriebsart die Schleifenverbindung zwischen dem Ausgang der Bestimmungseinrichtungen (MP/MC) eines abgeleiteten Signals (DSCP) und dem Bezugsoszillator (OSC2) oder dem ersten Bauteil (OSC1, R) unterdrückt wird, wenn der Wert des abgeleiteten Signals (DSCP) oder die Flankensteilheit aufgrund der Veränderung dieses Werts größer als ein erster bestimmter Schwellwert ist, wobei die Bestimmungseinrichtungen (MP/MC) eines abgeleiteten Signals (DSCP) erneut durch eine Schleife mit dem Bezugsoszillator (OSC2) oder mit dem ersten Bauteil (OSC1, R) verbunden werden, wenn der Wert des abgeleiteten Signals (DSCP) oder die Flankensteilheit aufgrund der Veränderung dieses Werts geringer als ein zweiter bestimmter Schwellwert ist.

15. Vorrichtung nach einem der vorhergehenden Ansprüche, die dazu bestimmt ist, die Messung und die Erfassung von Veränderungen von mindestens zwei Eingangssignalen durchzuführen, wobei die Synchronisationseinrichtungen (S) es ermöglichen, eines der Eingangssignale selektiv zu verarbeiten.

16. Vorrichtung nach Anspruch 15 und Anspruch 6, die mindestens zwei Messsensoren (Ma, Mb, Mc) und Umschalteinrichtungen enthält, die von den Synchronisationseinrichtungen gesteuert werden, um selektiv das von einem der Messsensoren kommende Signal zu verarbeiten, wobei ein einziger Oszillator (OSC1) hinter den Umschalteinrichtungen angeordnet ist, wobei dieser Oszillator von den Synchronisationseinrichtungen (S) gesperrt werden kann.

17. Vorrichtung nach Anspruch 15 und Anspruch 6, die mindestens zwei Messsensoren (Ma, Mb, Mc) und einen zugeordneten Oszillator (OSC1a, OSC1b, OSC1c) hinter jedem der Messsensoren (Ma, Mb, Mc) enthält, wobei die Synchronisationseinrichtungen (S) konzipiert sind, um den Ausgang eines zu verarbeitenden Oszillators auszuwählen und den Ausgang dieser Oszillatoren zu sperren.

18. System, das mindestens zwei Vorrichtungen nach einem der vorhergehenden Ansprüche enthält, bei dem gemeinsame Synchronisationseinrichtungen (S) es ermöglichen, alternativ die Schwingungen des ersten Bauteils der verschiedenen Vorrichtungen des Systems zu sperren.

19. Matrixartige taktile Tastatur, die zwei Gruppen von Elektroden (EI) zur Bildung der Zeilen und Spalten der Tastenmatrix und eine Vorrichtung nach einem der Ansprüche 15 bis 17 oder ein System nach Anspruch 18 enthält, bei der die Eingangssignale von den Elektroden (EI) kommen.

20. Tastatur nach Anspruch 19, bei der die Synchronisationseinrichtungen (S) alternativ die ersten Bauteile (M, OSC1) sperren, die mit bestimmten Elektroden (EI) der Tastatur verbunden sind, indem sie den Betrieb anderer erster Bauteile (M, OSC1) erlauben, die mit den anderen Elektroden (EI) der Tastatur verbunden sind.

21. Tastatur nach einem der Ansprüche 19 oder 20, bei der die Synchronisationseinrichtungen (S) sowohl eine Sperrung eines ersten Bauteils (M, OSC1) als auch die Verbindung der entsprechenden Elektrode (EI) mit Masse steuern.
